Europäisches Patentamt

European Patent Office

Office européen des brevets

(11) Numéro de publication: **0 266 268 B1**

# FASCICULE DE BREVET EUROPEEN

(45) Date de publication de fascicule du brevet: **22.07.92**

(51) Int. Cl.⁵: **H01L 21/314**, H01L 21/316, H01L 21/318, H01L 21/28

(21) Numéro de dépôt: **87402397.1**

(22) Date de dépôt: **23.10.87**

(54) **Procédé de dépot en phase vapeur à flash thermique d'une couche isolante sur un substrat en matériau III-V, application à la fabrication d'une structure MIS.**

(30) Priorité: **27.10.86 FR 8614896**

(43) Date de publication de la demande:
**04.05.88 Bulletin 88/18**

(45) Mention de la délivrance du brevet:
**22.07.92 Bulletin 92/30**

(84) Etats contractants désignés:
**DE FR GB**

(56) Documents cités:
**WO-A-86/05320**
**US-A- 4 371 587**
**US-A- 4 532 695**

**EXTENDED ABSTRACTS OF THE 16TH (1984 INTERNATIONAL) CONFERENCE ON SOLID STATE DEVICES AND MATERIALS, Kobe, 30 août - 1 septembre 1984, pages 663-666, Tokyo, JP; N. HAYAFUJI et al.: "Photo-CVD dielectric films on InP"**

**PATENT ABSTRACTS OF JAPAN, vol 6, no. 67 (E-104)[945], 28 avril 1982; & JP-A-57 10 240**

(73) Titulaire: **Nissim, Yves**
**14, rue des Pavillons**
**F-92800 Puteaux(FR)**

Titulaire: **BENSOUSSAN, Marcel**
**881 Cours Aquitaine**
**F-92100 Boulogne(FR)**

(72) Inventeur: **Nissim, Yves**
**14, rue des Pavillons**
**F-92800 Puteaux(FR)**
Inventeur: **Bensoussan, Marcel**
**991 Cours Aquitaine**
**F-92100 Boulogne(FR)**

(74) Mandataire: **Mongrédien, André et al**
**c/o BREVATOME 25, rue de Ponthieu**
**F-75008 Paris(FR)**

REVUE DE PHYSIQUE APPLIQUEE, vol. 19, no. 2, février 1984, pages 155-159, Qrsay, FR; R. CARMQNA et al.: "The role of plasma oxide in InP MIS structures"

JQURNAL QF THE ELECTRQCHEMICAL SQ-CIETY, vol. 124, no. 11, novembre 1977, pages 1781-1784; K.V. VAIDYANATHAN et al.: "Study of encapsulants for annealing GaAs"

THIN SQLID FILMS, vol. 64, no. 1, novembre 1979, pages 49-55, Elsevier Sequoia S.A., Lausanne, CH; C.W. WILMSEN et al.: "Interface formation of deposited insulator layers on GaAs and InP"

APPLIED PHYSICS LETTERS, vol. 42, no. 11, 1 juin 1983, pages 950-952, American Institute of Physics, New York, US; F.H.P.M. HABRA-KEN et al.: "Surface and interface nitridation of thin polycrystalline silicon films"

## Description

L'invention a pour objet un procédé de dépôt en phase vapeur d'une couche isolante électriquement sur un substrat en matériau III-V, utilisable en particulier soit comme isolant de grille de structure MIS (transistor, CCD, mémoire) soit comme couche de passivation de surface.

On rappelle qu'un matériau III-V est un matériau contenant au moins un élément de la colonne III et au moins un élément de la colonne V de la classification périodique des éléments.

L'obtention d'isolants électriques ayant des propriétés satisfaisantes (états d'interface, tenue électrique, tenue mécanique, porosité, tenue dans le temps...), tant pour les isolants de grille des transistors MIS que pour les isolants de passivation et de protection des circuits intégrés, constitue encore la grande limitation à l'utilisation extensive des composés III-V en microélectronique et dans l'intégration optoélectronique. En particulier à ce jour il n'existe pas encore de procédé technologique entièrement satisfaisant pour la réalisation de structures MIS (Métal-Isolant-Semiconducteur) sur GaAs, InP, $Al_xGa_yIn_{1-x-y}As$ ou $Ga_xIn_{1-x}As_yP_{1-y}$ avec $0 \leq x \leq 1$ et $0 \leq y \leq 1$ qui sont les matériaux de base en technologie III-V.

La raison essentielle à cet état de chose est que, contrairement au silicium, les composés III-V ne possèdent pas d'oxydes natifs stables ayant les propriétés électroniques adéquates pour l'isolation électrique.

L'oxydation thermique de ces composés, qui aurait été la voie naturelle pour la réalisation d'isolants, est complexe et nécessite des conditions de pression assez peu courantes. D'ailleurs les essais dans ce sens ne sont pas encore très probants comme le montre le document "High pressure thermal oxyde/InP interface", de C.W. Wilmson et al, J. Vac. Sci. Technol. B 3 (4) 1103 (1985).

Il semble même que la couche d'oxydes natifs (0,1 nm environ) constitue une limitation à la qualité des propriétés électriques d'interface comme l'indique le document "Influence of interfacial structure on the electronic properties of $SiO_2$/InP MISFET'S", de K.M. Geib et al, J. Vac. Sci. Technol B 2 (3) 516 (1984).

De plus, il existe un certain nombre d'oxydes possibles avec l'un ou l'autre des éléments de ces composés III-V ou même avec une combinaison des deux conduisant à des mélanges de phases dont certaines sont instables comme l'indique le document "Analysis of native oxide films and oxyde-substrate reaction on III-V semiconductors using thermochemical phase diagrams" de G.P. Schwartz paru dans Thin Solid film - 103 (3) 1983.

Donc, la seule voie possible, qui est exploitée actuellement, est celle des isolants rapportés ou déposés.

Les isolants les plus utilisés sont $SiO_2$ et $Si_3N_4$. Ceci tient au fait qu'il est proposé dans le commerce des procédés de dépôts de ces matériaux bien maîtrisés qui ont été mis au point dans la technologie du silicium qui est également demanderesse d'isolants déposés.

Une des limitations essentielle à l'utilisation, sans précautions particulières, de ces techniques de dépôt pour les composés III-V est la tension de vapeur saturante de l'élément V qui est bien plus élevée que celle de l'élément III. Par exemple, les températures de décomposition non congruente de surface de InP et de GaAs sont respectivement de l'ordre de 300°C et 550°C ; au-dessus de ces températures il y a évaporation préférentielle de l'élément V, laissant en surface un excès d'élément III qui a tendance à former des agrégats métalliques conduisant à des états d'interface peu satisfaisants.

Cette limitation de température a conduit tout naturellement, jusqu'à présent, à s'orienter pour les composés III-V vers des processus de dépôt d'isolants dits "basse température", c'est-à-dire à des températures inférieures à la température de décomposition non congruente de la surface du substrat, soit à des températures inférieures à 300°C dans le cas de InP.

Tout d'abord, les isolants furent déposés par des dépôts chimiques en phase vapeur traditionnels. Malgré tous les efforts faits dans ce sens ces techniques ont presque toujours conduit à une densité d'états électroniques d'interface interdisant toute réalisation d'un composant utilisable. Il est bien établi que les isolants dits "basse température" sont de moins bonne qualité que ceux réalisés à plus haute température.

Le raisonnement intuitif consistant à rechercher des procédés de dépôts permettant d'abaisser encore la température de dépôt a conduit à la mise au point de procédés tels que le dépôt chimique en phase vapeur assisté par plasma et le dépôt chimique en phase vapeur assisté par rayonnement ultraviolet.

Bien que ce ne soit pas encore totalement satisfaisant, des résultats encourageants ont été obtenus par ces deux derniers procédés.

Dans le dépôt assisté par ultraviolet, décrit dans la communication donnée aux Journées de la Société Française du Vide, Paris, 22-23 octobre 1984, "Dépôt de couches minces diélectriques ($SiO_2$, $Si_3N_4$) en CVD assisté par UV (Hg) sur matériaux III-V" de P. Dimitriou - A. Scavennec, il semble que la qualité de l'isolant a été un peu améliorée.

Inversement, pour le dépôt assisté par plasma, décrit dans les documents "Interface properties of metal/oxide/semiconductor and metal/semiconductor structures on $Ga_{1-x}In_xAs$ with $x = 0.35$ and 0.10", de S. Gourier et al, paru dans Thin Sol. Films 103 155 (1983) et "High resolution electron microscopy of the $GaAs/Si_3N_4$ interface produced by multipolar plasma deposition" de P. Ruterana et al., paru dans Appl. Phys. Lett. 49 (11), p. 672, du 15 septembre 1986, c'est plutôt l'aspect de préparation ou de conditionnement de la surface du substrat, avant de déposer l'isolant, qui offre des perspectives intéressantes, sans que ce soit encore vraiment probant.

De ces études, il apparaît aussi une deuxième limitation aux dépôts d'isolants sur des substrats en matériau III-V, deuxième limitation liée au conditionnement de la surface des substrats, avant le dépôt des isolants.

Pour le GaAs, les propriétés de surface font que, quelle que soit la technique de dépôt, le niveau de Fermi est bloqué au milieu de la bande interdite par plus de $10^{12}$ états d'interface/cm², nombre qu'aucune technique à ce jour n'a pu réduire. Dans ce cas, les procédés existants s'attachent surtout à préserver la stoëchiométrie, en surface, du substrat.

En revanche, pour l'InP ou le $Ga_xIn_{1-x}As$, avec $0 \leqq x \leqq 1$, il est possible d'obtenir des structures MIS de bonne qualité. Les niveaux de Fermi pour ces derniers composés ne sont pas bloqués de façon rédhibitoire en surface et, suivant la manière dont on conditionne ou prépare la surface du substrat, on peut réduire le nombre d'états d'interface de façon significative. Il est donc clair que pour InP et $Ga_xIn_{1-x}As$, l'étape de préparation de la surface du substrat, avant le dépôt d'isolant, est cruciale.

La présente invention a justement pour objet un procédé de dépôt d'une couche isolante sur un substrat en matériau III-V permettant de remédier aux différents inconvénients ci-dessus. Elle permet notamment l'obtention de couches isolantes ayant des propriétés électriques, mécaniques, de tenue dans le temps, d'interface, etc. tout à fait satisfaisantes.

Elle est basée sur la technique de dépôt chimique en phase vapeur connue sous l'abréviation dépôt CVD, et sur l'utilisation d'un traitement thermique rapide ou flash thermique du substrat.

Il est à noter que le traitement thermique rapide est actuellement connu pour recuire des substrats en GaAs implantés en vue d'activer électriquement les ions implantés. Un certain nombre de propriétés spécifiques à ce recuit est décrit dans l'article "Rapid thermal annealing of ion implanted semiconductors", de J. Narayan, O.W. Holland, Journal of Appl. Phys. 56, 2913 (1984).

De façon plus précise, l'invention a pour objet un procédé de formation d'une couche électriquement isolante sur un substrat en matériau III-V, caractérisé en ce qu'il comprend au moins une première étape de préparation de la surface du substrat pour mettre à nu ladite surface ou pour la recouvrir d'au moins une couche de protection et une seconde étape de dépôt chimique en phase vapeur de ladite couche isolante, à haute température, c'est-à-dire à une température supérieure à la température de décomposition non congruente de la surface du substrat, le chauffage du substrat au cours de la seconde étape étant réalisé par un flash thermique correspondant à une montée en température extrêmement rapide voisine de 5 secondes, une descente en température extrêmement rapide voisine de 12 secondes et un palier à la température de dépôt choisie dont la durée est fonction de l'épaisseur recherchée pour la couche isolante.

Autrement dit, la haute température est produite par l'irradiation flash du substrat.

Les première et seconde étapes sont réalisées de préférence dans une même enceinte. En outre, la première étape est avantageusement réalisée en soumettant le substrat à un flash thermique.

Par haute température, il faut comprendre des températures supérieures à 300°C dans le cas de InP. En outre, par substrat, il faut comprendre un substrat massif mais aussi toute couche épitaxiée ou déposée sur un substrat massif, et toute région implantée dans un substrat massif.

Le procédé de l'invention allie les avantages bien connus du dépôt chimique en phase vapeur tels que ta souplesse d'utilisation de différents gaz, de la pression de ces gaz, la possibilité de nettoyage de la surface du substrat in situ etc. En outre, du fait de la décomposition en surface des substrats III-V à haute température, la technique de dépôt chimique en phase vapeur par flash thermique permet de réaliser rapidement des changements de températures donnant ainsi la possibilité de jouer sur la cinétique des phénomènes de surface des substrats.

De façon avantageuse, le flash thermique correspondant à un chauffage thermique de courte durée est effectué dans un four à lampes à halogène. La durée du flash thermique dépend de la nature du substrat et en particulier de la température de décomposition du substrat.

Le four à halogène permet :

1°) - un temps de montée $t_M$ en température extrêmement rapide, voisin de 5 secondes, même pour des températures élevées telles que 1200°C, et contrôlable,

2°) - une parfaite stabilité sur le palier de température choisi, au moyen d'une contre-réaction analysant directement la température induite sur l'échantillon par thermocouple ou pyromètre optique,

3°) - un temps de descente $T_D$ en température extrêmement rapide, équivalent à une trempe du substrat, et contrôlable, $T_D$ étant voisin de 12 secondes,

4°) - un chauffage localisé sur le substrat lié à de l'absorption optique pour celui-ci.

Dans un four lampe halogène, l'homogénéité en température est assurée par la géométrie des lampes et le montage de l'échantillon à traiter est sans contact thermique avec son support (échantillon flottant) assurant ainsi une faible inertie thermique. Cette dernière propriété permet de mettre en évidence un avantage supplémentaire du procédé de l'invention (dépôt CVD par flash thermique).

En effet, le chauffage s'effectuant localement sur l'échantillon, l'ensemble du four a ses parois froides. Ceci élimine complétement tout risque de pollution de ces parois et donc des échantillons ainsi que tout problème d'autodopage de ces derniers. De plus, le procédé de dépôt étant de courte durée (quelques secondes), les phénomènes de rediffusion des impuretés dans l'échantillon sont également fortement réduits.

Ainsi, le problème d'instabilité de la surface des substrats en matériau III-V, lié au départ préférentiel de l'élément V lors d'un chauffage à haute température, est résolu selon l'invention, par le recuit flash des substrats. En effet, il a été montré, par l'article de Narayan ci-dessus, qu'un substrat en GaAs, donc en matériau III-V, pouvait supporter des hautes températures pour des temps d'irradiation inférieurs à la minute.

A titre d'exemple, le GaAs non protégé peut supporter une température de 850°C pendant quelques secondes (5 à 10 sec) sans risque de dégradation, et l'InP une température de 720°C pendant la même durée.

L'utilisation selon l'invention de hautes températures (>300°C), pour un dépôt CVD d'isolants par flash thermique, permet d'obtenir des isolants de bonne qualité en volume, du fait de leur bonne stœchiométrie ayant des résistivités supérieures à celles que l'on obtient par les techniques de dépôt à basse température. En effet, meilleure est la stœchiométrie de l'isolant, plus le mouvement des charges libres dans l'isolant, qui sont responsables des phénomènes d'hystérésis dans les caractéritiques courant-tension d'une structure MIS par exemple, est réduit.

En outre, l'utilisation de hautes températures induites par flash thermique selon l'invention permet également de gagner en vitesse de croissance de la couche d'isolant et donc d'autoriser des temps d'irradiation courts. Ces deux paramètres sont fonction de la réaction chimique de dépôt sélectionnée.

Selon l'invention, l'étape de dépôt chimique peut être réalisée à pression atmosphérique ou à basse pression (inférieure à 133 Pa), chacune de ces solutions ayant ses avantages et ses inconvénients. Toutefois, le dépôt chimique en phase vapeur basse pression donne les meilleurs dépôts du point de vue de l'uniformité.

Le procédé selon l'invention est applicable à tous substrats en matériau III-V et en particulier aux substrats en InP, $Ga_xIn_{1-x}As_yP_{1-y}$, $Ga_yAl_{1-y}As$, $Al_xGa_yIn_{1-x-y}As$, avec $0{\leq}x{\leq}1$ et $0{\leq}y{\leq}1$, GaSb, InSb, GaP. Etant donné que les matériaux de base en technologique III-V sont le GaAs, l'InP, le $Ga_xIn_{1-x}As_yP_{1-y}$ et le $Al_xGa_yIn_{1-x-y}As$ avec $0{\leq}x{\leq}1$ et $0{\leq}y{\leq}1$, le procédé selon l'invention s'applique de préférence à ces matériaux.

L'étape de préparation de la surface du substrat en matériau III-V peut comporter une étape de nettoyage chimique, étape très efficace pour un substrat en InP, réalisée en dehors de l'enceinte de dépôt chimique en phase vapeur. Le nettoyage permet la mise à nu de la surface du substrat semiconducteur, en éliminant notamment l'oxyde natif, sans créer de défaut supplémentaire.

L'étape de préparation de la surface du substrat peut aussi comporter une étape de décapage réalisée dans l'enceinte de dépôt. Cette étape peut être précédée par l'étape de nettoyage chimique ci-dessus ; elle sert aussi à mettre à nu la surface du substrat, sans création de défaut supplémentaire.

Cette étape de décapage est réalisée en soumettant le substrat à un flash thermique à l'aide de lampes à halogène, soit sous vide pour dégager les quelques nanomètres d'oxydes natifs, soit en présence d'un gaz chloré tel que $CCl_4$, $SiCl_4$ ou $GeCl_4$.

Lorsque le décapage est réalisé sous vide, la température induite par les lampes halogènes sur le substrat est de 300°C pour InP, et de 550°C pour GaAs.

La durée d'irradiation thermique et celle d'action du gaz chloré, pour un substrat en GaAs, varient entre 3 et 15 secondes et pour un substrat en InP entre 1 et 10 secondes.

L'étape de préparation de la surface du substrat peut comporter, en plus des étapes ci-dessus, une étape d'apport en éléments V à la surface du substrat. Cette étape d'apport peut constituer à elle seule l'étape de préparation de la surface du substrat.

Cet apport en élément V permet de compenser les lacunes de cet élément à la surface du substrat. Cet apport est réalisé en soumettant la surface du substrat à un flash thermique, l'irradiation du substrat étant produite par des lampes à halogène, en présence d'un flux de $As_2$ ou de $P_2$, obtenu par décomposition thermique de $AsH_3$ ou de $PH_3$, dans l'enceinte de dépôt.

$As_2$ et $P_2$ peuvent être utilisés pour n'importe lequel des substrats en matériau III-V, et en particulier aussi bien pour GaAs, InP, $Ga_xIn_{1-x}As_yP_{1-y}$ et $Al_xGa_xIn_{1-x-y}As$ avec $0 \leqq x \leqq 1$ et $0 \leqq y \leqq 1$.

Dans le cas particulier d'un substrat en InP, le traitement flash thermique sous flux de $As_2$ améliore de beaucoup les propriétés électroniques de la surface de ce substrat, du point de vue de sa passivation, par formation d'une couche semiconductrice contenant de l'indium et de l'arsenic, cette couche ayant une épaisseur de quelques dizièmes de nanomètres (0,3 à 3 nm).

La durée du flash thermique et de l'apport en élément V est comprise entre 1 et 10 secondes pour InP et entre 3 et 15 secondes pour GaAs ; la température induite par l'irradiation flash sur le substrat est comprise entre 500 et 700°C pour InP et entre 700 et 900°C pour GaAs.

L'étape de préparation de la surface du substrat peut aussi consister en une étape d'encapsulation de cette surface par une couche protectrice très mince en matériau isolant. Cette étape d'encapsulation peut être utilisée seule ou bien combinée avec les étapes précédentes. Le matériau isolant peut être un nitrure ou un sulfure ayant réagi avec l'oxyde natif du substrat ou bien de l'oxyde de silicium ($SiO_2$) déposé, de quelques nanomètres.

La nitruration ou la sulfuration de la surface du substrat sont réalisées avantageusement en soumettant la surface de ce substrat à un flash thermique, réalisé à l'aide de lampes à halogène.

Pour un substrat en InP, la nitruration sous flash thermique se fait à une température de 600°C pendant 3 à 10 secondes avec du $NH_3$.

La sulfuration sous flash thermique peut être réalisée avec du $SH_2$ à une température de 550°C, pendant 3 à 15 secondes, pour un substrat en GaAs et à une température de 300°C, pendant 3 à 10 secondes pour InP.

Lorsque la couche d'encapsulation est réalisée en $SiO_2$, le dépôt de cette couche peut êtrê réalisé par craquage de $SiH_4$ en présence d'oxygène à une température de 250 à 450°C ou par craquage de Si-$(OC_2H_5)_4$ en présence d'oxygène à une température de 300 à 500°C.

Elle peut aussi être réalisée en déposant par CVD à haute température induite par flash thermique une couche de silicium polycristallin non dopé que l'on oxyde thermiquement sous atmosphère d'oxygène, comme décrit dans le document "Rapid thermal processing of thin gate dielectrics. Oxydation of silicon" de J. Nulman, J.P. Krusius and A. Gat paru dans IEEE elec. Dev. Lett. Vol 6, 5, 205 (1985).

Cette couche de $SiO_2$ permet au substrat protégé, destiné à former la couche active d'une structure MIS notamment, de supporter la haute température utilisée pour le dépôt de la couche isolante pendant des durées pouvant dépasser la dizaine de minutes.

L'étape d'encapsulation de la surface du substrat peut aussi consister en une épitaxie d'une couche semiconductrice de quelques nanomètres, jouant aussi le rôle de couche protectrice du substrat destiné à constituer la couche active d'une structure MIS par exemple. Cette étape est réalisée juste après le décapage par flash thermique.

Cette épitaxie est réalisée à haute température ).300°C) par décomposition thermique de vapeurs organométalliques, technique connue sous l'abréviation MOCVD, et pouvant se faire dans le même bâti de dépôt que les autres dépôts. Cette décomposition peut être réalisée par chauffage continu ou par flash thermique de la surface du substrat réalisé au moyen de lampes à halogène, selon l'invention.

La couche semiconductrice épitaxiée peut être formée d'élément III et d'élément V identiques ou différents de ceux constituant le substrat en matériau III-V. Par exemple pour InP, la couche épitaxiée peut être en InP ou InAs, etc. et pour GaAs la couche épitaxiée peut être en GaAS, GaP, etc.

Conformément à l'invention, la couche isolante déposée sur le substrat en matériau III-V peut être une couche de silicium polycristallin non dopé, une couche de nitrure de silicium ($Si_3N_4$) ou une couche d'oxyde de silicium ($SiO_2$) de quelques dizaines de nanomètres.

Pour une couche en silicium polycristallin non dopé, le dépôt peut être réalisé par craquage du $SiH_4$ ou du $SiH_2Cl_2$ à des températures allant de 800 à 1100°C. Par exemple, ce dépôt, d'une épaisseur de 30 nm environ, est réalisé en soumettant le substrat à un flash thermique, à l'aide de lampes à halogène ; la température d'irradiation est de 920°C pendant 3 secondes.

Cette couche de silicium polycristallin, qui peut être utilisée en tant que telle, peut ensuite être oxydée ou nitrurée comme indiqué dans le document de Nulman cité ci-dessus à haute température en présence réciproquement d'oxygène ou d'azote, cette oxydation ou nitruration se faisant sous irradiation thermique du substrat l'aide d lampes à halogène, dans le même bâti de dépôt.

Par ailleurs, il est possible de déposer directement une couche de nitrure ou une couche d'oxyde de silicium par réaction chimique de certains gaz, à haute température induite par flash thermique, dont les plus courantes sont rappelées ci-après.

Chacune de ces réactions chimiques est à optimiser en fonction de la température laquelle est porté le substrat, lorsqu'il est soumis à une irradiation thermique émise par des lampes à halogène et en fonction des pressions partielles des différents constituants gazeux. La durée du dépôt de l'isolant et de l'irradiation croît avec l'épaisseur d'isolant voulue ; cette durée est comprise entre 5 et 120 s.

Les réactions chimiques mises en jeu pour le dépôt d'une couche isolante en $SiO_2$ sont données dans le tableau 1 ci-après, et celles mises en jeu pour le dépôt d'une couche isolante en $Si_3N_4$ sont données dans le tableau 2 ci-après.

## TABLEAU 1

| mélanges gazeux | température de dépôt en °C |
|---|---|
| $Si(OC_2H_5)_4 + O_2$ | 600 – 900 |
| $SiCl_4 + CO_2 + H_2$ | 1000 – 1300 |
| $SiCl_4 + N_2O$ | 1000 – 1200 |
| $SiBr_4 + N_2O$ | 800 – 1000 |
| $SiH_4 + CO_2 + H_2$ | 800 – 1100 |
| $SiH_2Cl_2 + N_2O$ | 800 – 900 |
| $SiH_4 + N_2O$ | 700 – 800 |
| $SiH_4 + O_2$ | 450 – 750 |

## TABLEAU 2

| mélanges gazeux | température de dépôt en °C |
|---|---|
| $SiH_4 + NH_3$ | 700 – 1100 |
| $SiH_2Cl_2 + NH_3$ | 700 – 900 |

Dans toutes ces réactions chimiques, pour avoir des vitesses de croissance correcte de la couche isolante (de 10 à 100 nm/min), il faut que le composé gazeux comportant le silicium soit suffisamment dilué et que la concentration en l'élément oxydant ou nitrurant soit élevé.

Dans le cas d'une couche en $SiO_2$ :

$O_2/SiH_4 = 10$.

Pour de plus amples détails sur les réactions de dépôt ci-dessus on peut par exemple se référer à l'article "Low pressure CVD production processes for poly, Nitride and Oxide" de R.S. Rosler, paru dans Solid State Tech., April 1977, 63, et à l'article "Comparaison of properties of dielectric films deposited by various method" de W.A. Plishin, paru dans J. Vac. Sci. Technol 14 1064 (1977).

La couche isolante peut aussi être réalisée en phosphure de silicium connu sous l'abréviation de PSG par craquage du mélange $SiH_4$ + $PH_3$ en présence d'oxygène, une température de 300 à 500°C. L'avantage d'une telle solution est, en plus de la couche isolante, d'apporter à la surface du substrat l'élément V permettant ainsi d'éviter l'étape d'apport décrite précédemment.

Le procédé de dépôt en phase vapeur par flash thermique décrit précédemment s'applique avantageusement à la réalisation d'une structure MIS telle qu'un transistor, un point mémoire, un registre à décalage, etc.

A cet effet, l'invention a aussi pour objet un procédé de fabrication d'une structure MIS sur un substrat en matériau III-V, comportant une couche électriquement isolante surmontée d'une couche conductrice, ce procédé comportant une étape de préparation de la surface du substrat et une étape de dépôt chimique en phase vapeur de la couche isolante telles que décrites précédemment ainsi qu'une étape de dépôt de la couche conductrice, à haute température.

Le dépôt de la couche conductrice est réalisé avantageusement juste après le dépôt de la couche isolante, dans la même enceinte de dépôt, évitant ainsi tout risque de pollution par le milieu ambiant.

La couche conductrice peut être une couche de silicium polycristallin fortement dopé avec du phosphore déposée sous flash thermique, à l'aide de lampes à halogène. Ce dépôt résulte par exemple d'un craquage de $SiH_4$ et de $PH_3$.

La couche conductrice peut aussi être réalisée en métal tel que le nickel, le tungstène,le molybdène, le tantale, etc.

Cette couche métallique peut alors être formée par pyrolyse de carbonyle ou d'hexafluorure du métal correspondant en utilisant notamment une irradiation par flash selon l'invention ou une irradiation laser comme décrit dans l'article "Metal Film Deposition by Laser Breakdown chemical Vapor Deposition" de T.R. Jervis and L.R. Newkirk paru dans "Beam induced Chemical Processes" édité par R.J. Von Gutfeld, J.E. Greene, H. Schlossberg (M.R.S. Pittsburg 1985), p. 7.

La durée du flash thermique, pour le dépôt du silicium polycristallin, et celle de l'irradiation laser, pour le dépôt de la couche métallique, sont comprises entre 5 secondes et quelques minutes, suivant l'épaisseur de la couche conductrice désirée.

La température de dépôt de la couche conductrice est comprise entre 700 et 950°C suivant la nature de cette couche.

Cette couche conductrice peut aussi être réalisée en un siliciure de tungstène ou de molybdène en déposant successivement une couche de silicium polycristallin et une couche de tungstène ou de molybdène. Le tungstène ou le molybdène déposé à haute température réagit avec le silicium polycristallin pour former le siliciure correspondant.

D'autres caractéristiques et avantages de l'invention ressortiront mieux de la description qui va suivre, donnée à titre illustratif et non limitatif en référence aux figures annexées, dans lesquelles :

- les figures 1 à 6 illustrent les différentes étapes de fabrication d'une structure MIS, conformément à l'invention : les figures 1, 2a à 6 sont des coupes longitudinales de la structure MIS et la figure 2b est un diagramme donnant, au cours du temps (t), le cycle de température (T) et d'introduction des gaz dans l'enceinte de dépôt pour la fabrication d'une structure MIS en InP, et
- la figure 7 représente schématiquement un dispositif permettant la mise en oeuvre du procédé selon l'invention.

La description ci-après se réfère à la fabrication d'un transistor MIS réalisé sur un substrat en InP en vue d'une simplification de cette description. Toutefois, comme on l'a dit précédemment, l'invention est d'application beaucoup plus générale.

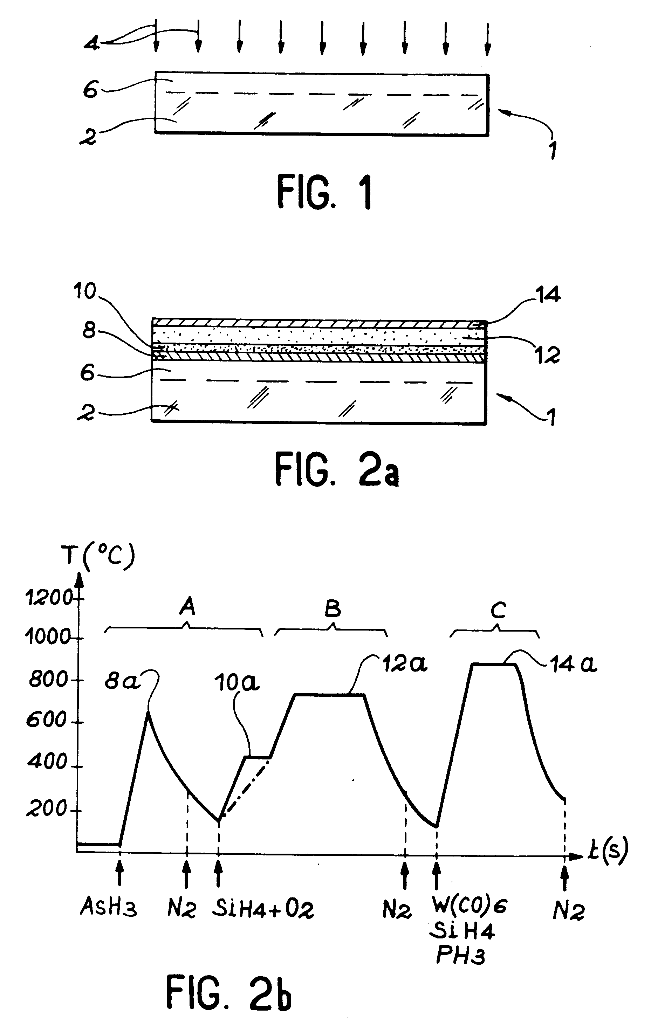

Sur la figure 1, l'échantillon à traiter, de référence générale 1, comporte un substrat en InP semi-isolant 2, dopé en particulier avec des ions fer, pourvu à sa surface d'une région dopée 6 qui constitue la couche active de la structure MIS. Cette couche 6 est formée par implantation ionique 4. Cette implantation 4 est réalisée en particulier avec des ions de type n à une dose de $5.10^{15}$ à $10^{16}$ atomes/cm$^2$. Comme ions de type n, on peut citer le silicium, le sélénium, le soufre, etc.

Au lieu de l'implantation ionique, la couche active de la structure MIS peut aussi être réalisée par épitaxie d'une couche semiconductrice sur le substrat 2 par décomposition thermique d'organo-métalliques, de phosphine et/ou d'arsine, obtenue par chauffage continu ou flash thermique de la surface au moyen de l'irradiation de la surface par des lampes à halogène, selon l'invention.

L'étape suivante du procédé, notée A sur la figure 2b, consiste à préparer la surface de la couche implantée 6 du substrat en vue d'y déposer la couche isolante qui constituera l'isolant de grille de la structure MIS.

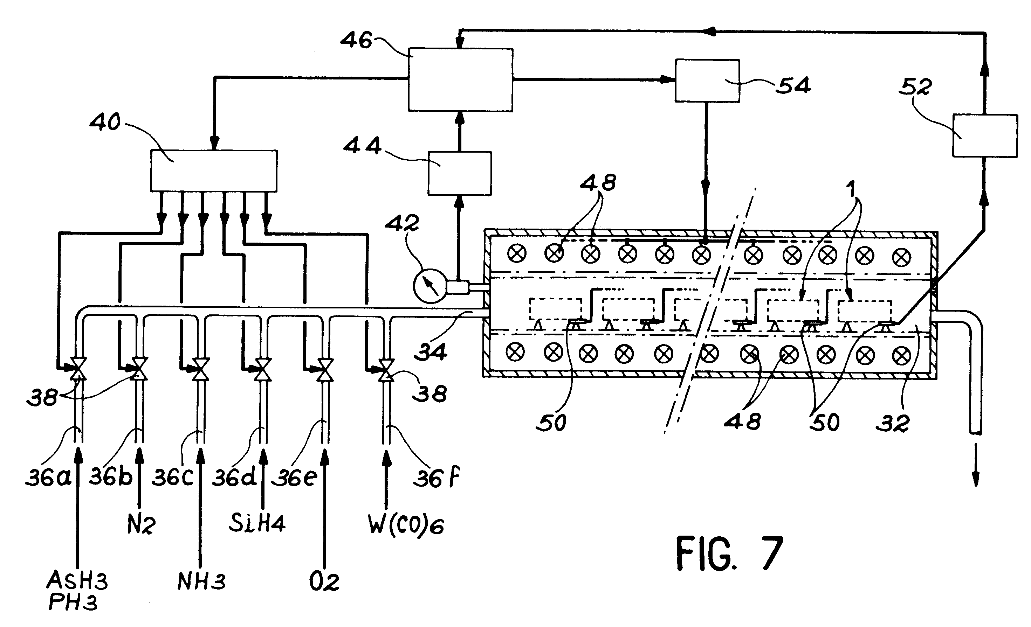

Cette étape A consiste à soumettre la surface implantée du substrat à un flux de $As_2$, obtenu à partir de la décomposition thermique 8a de $AsH_3$ dans une enceinte à vide (référence 32 à la figure 7) où règne un vide de l'ordre de $1,3.10^{-4}$ Pa, afin de former une monocouche 8 à base d'arsenic et d'indium, comme représenté sur la figure 2a. Cette étape A pouvant également être réalisée à pression atmosphérique.

La couche semiconductrice 8 permet de saturer en élément V la surface implantée 6 du substrat, mais aussi de la protéger, lors du dépôt ultérieur de la couche isolante à haute température.

Le dépôt de la couche semiconductrice 8 qui est réalisé en soumettant à une irradiation thermique la surface implantée du substrat, est effectué à une température de 650°C, pendant une durée de 1 à 10 secondes, comme l'indique la figure 2b, cette irradiation provenant de lampes à halogène (référence 48 sur la figure 1). Le dépôt 8 est suivi d'une purge de l'enceinte à vide par un gaz neutre tel que l'azote (figure 2b).

L'étape A de préparation se poursuit par le dépôt sur la couche semiconductrice 8 d'une couche isolante 10 (figure 2a) constituant une auto-encapsulation de la surface implantée 6 du substrat ou de la couche épitaxiée, permettant de protéger cette couche implantée ou épitaxiée lors du dépôt ultérieur de la couche isolante à haute température par flash thermique.

En effet, cette auto-encapsulation permet à la couche implantée 6 ou épitaxiée de supporter la haute température souhaitée pour le dépôt ultérieur d'un bon isolant, pendant des durées pouvant dépasser la dizaine de secondes fatidiques à la décomposition du substrat.

La couche isolante 10 est en particulier une couche de $SiO_2$ de 3 à 5 nm environ obtenue par décomposition thermique 10a de $SiH_4$ en présence de $O_2$, à une température de 450°C pendant 3 à 10 secondes, comme représenté sur la figure 2b ou 300°C pour des temps de l'ordre de la minute. Le dépôt de cette couche 10 en $SiO_2$ est obtenu au moyen d'une irradiation de la surface de l'échantillon 1, avec des lampes à halogène.

Après purge de l'enceinte à vide avec de l'azote (figure 2b), on effectue sur la couche isolante 10, le dépôt B (figure 2b) d'une autre couche isolante 12 (figure 2a) qui constituera l'isolant de grille de la structure MIS. Cette couche isolante 12, de 50 à 100 nm d'épaisseur, est en particulier une couche de $SiO_2$ obtenue comme la couche 10 par décomposition thermique 12a de $SiH_4$ en présence de $O_2$ (figure 2b), à une température de 750°C.

L'étape B de dépôt chimique en phase vapeur de la couche isolante 12, est réalisée l'aide d'une irradiation thermique de la surface de l'échantillon 1, au moyen de lampes à halogène.

La durée de l'irradiation thermique ainsi que celle de l'action du mélange gazeux varie de 5 à 30 secondes suivant l'épaisseur souhaitée pour la couche 12 en $SiO_2$.

L'étape suivante du procédé, notée C sur la figure 2b, consiste à compléter la structure MIS en déposant à la surface de l'isolant 12 une couche conductrice 14 (figure 2a). Cette couche conductrice 14 est en particulier une couche de siliciure de tungstène obtenue par craquage de $SiH_4$ et de $PH_3$ à 900°C (figure 2b) suivi d'une pyrolyse de carbonyle de tungstène, comme décrit dans l'article ci-dessus de T.R. Jervis. Cette pyrolyse est en particulier réalisée sous irradiation laser, à une température de 900°C et pendant 10 secondes environ, comme l'indique la figure 2b.

Cette température élevée du dépôt de la couche conductrice 14 permet en outre d'effectuer le recuit thermique de la couche implantée 6 du substrat, rendant les ions implantés électriquement actifs.

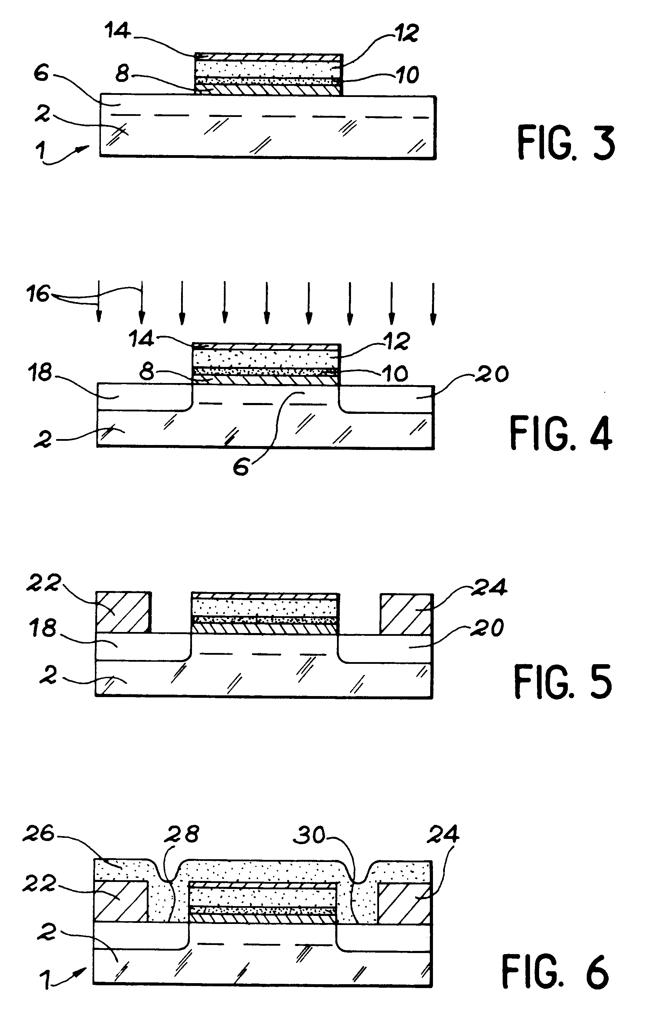

L'étape suivante du procédé consiste, comme représenté sur la figure 3, à graver l'empilement de couches 8, 10, 12, 14, selon les techniques classiques de lithographie, pour réaliser la grille de la structure MIS. Cette gravure est effectuée en utilisant un masque de résine définissant les dimensions de la grille de la structure MIS et en attaquant chimiquement et de façon sélective ces différentes couches, procédés bien connus de l'homme de l'art.

On effectue ensuite, comme représenté sur la figure 4, une implantation ionique 16, l'empilement des couches gravées 8 à 14 jouant le rôle de masque à cette implantation. Cette implantation permet de définir, la surface supérieure du substrat 2 et de part et d'autre de l'empilement gravé, deux régions implantées 18 et 20 représentant respectivement la source et le drain de la structure MIS.

Cette implantation est réalisée avec des ions de type n (Si, S, Se) à une dose de $10^{19}$ atomes/cm$^2$. Elle est suivie d'un recuit d'activation électrique des ions implantés par flash thermique comme décrit dans l'article de J. Narayan cité précédemment. Cette irradiation thermique est effectuée en particulier à une température de 700°C pendant 5 secondes environ, et est produite selon l'invention au moyen de lampes à halogène.

9

EP 0 266 268 B1

L'étape suivante du procédé consiste, comme représenté sur la figure 5, à réaliser les connexions 22 et 24 respectivement de la source 18 et du drain 20 de la structure MIS. Ces métallisations 22 et 24 sont réalisées en aluminium ou en titane-or-germanium par définition des dimensions de ces métallisations à l'aide d'une étape de lithographie réalisant un masque de résine, suivie d'un dépôt par évaporation sous vide du métal, puis d'une élimination de la résine, entraînant l'élimination du métal la recouvrant. Cette technique est connue sous le nom de "lift off" en terminologie anglo- saxonne.

La dernière étape du procédé consiste, comme représenté sur la figure 6, à déposer sur l'ensemble de la structure une couche isolante 26 de passivation. Cette couche isolante 26 est en particulier une couche de $SiO_2$ déposée dans les mêmes conditions opératoires que l'isolant de grille 12 (étape B, figure 2b) et après avoir soumis les zones du substrat 28 et 30 non métallisées à une étape de préparation A (figure 2b) de la surface, conforme à l'invention.

Sur la figure 7, on a représenté schématiquement un dispositif permettant la mise en oeuvre du procédé selon l'invention.

Ce dispositif à configuration horizontale comporte une enceinte à vide 32 dans laquelle sont placés, dans un tube quartz, plusieurs échantillons 1 à traiter en matériau III-V. Les supports échantillons doivent avoir une inertie thermique la plus faible possible et ne pas être en contact avec les échantillons (coussins de gaz par exemple).

Des gaz nécessaires à la préparation de la surface des échantillons, au dépôt de la couche isolante 12 et éventuellement de la couche conductrice 14 sont introduits à l'une des extrémités 34 de l'ensemble, l'autre extrémité étant utilisée par exemple pour la mise sous vide de l'enceinte 32.

Sur la figure 7, on a représenté six conduites d'amenée de gaz 36a à 36f. La conduite 36a sert par exemple à l'introduction des gaz apportant l'élément V à la surface des substrats III-V tels que $AsH_3$ ou $PH_3$ ; la conduite 36b sert à l'introduction d'un gaz neutre tel qu'un gaz rare ou de l'azote en vue de purger tout le dispositif entre chaque réaction chimique en phase gazeuse ; la conduite d'amenée 36c sert l'introduction des gaz de sulfuration ou de nitruration tels que $NH_3$ et $SH_3$ ; la conduite d'amenée 36d sert à l'introduction des gaz du silicium, donnés dans les tableaux 1 et 2 ; la conduite d'amenée 36e sert à l'introduction des composés oxygénés gazeux (voir tableaux 1 et 2) tels que $O_2$; la conduite d'amenée 36f sert l'introduction des composés métalliques gazeux tels que $W(CO)_6$.

Les conduites d'amenée 36a-36f des différents gaz sont équipées d'électro-vannes 38 reliées à un circuit électronique 40 de commande. Un manomètre 42, relié à un circuit électronique de lecture 44, permet de mesurer la pression régnant à l'intérieur de l'enceinte 32. Ces informations de mesure sont envoyées vers un calculateur 46 pilotant alors le circuit électronique de commande 40 des électro-vannes 38.

L'enceinte à vide 32 est placée dans un four à lampes à halogène 48 permettant de soumettre les échantillons 1, en regard des lampes, aux différents flashes thermiques, utilisés lors de la préparation du substrat, lors du dépôt de la couche isolante et éventuellement du dépôt de la couche conductrice.

Comme four à lampes à halogène utilisable, on peut citer le four "Machine Heat pulse" par A.G. Associates (Palo Alto, Californie USA, ou "Machine Addax" par AET (Chemin de malacher ZIRST, Meylan, France).

Des sondes de mesure de la température 50 (du type thermocouple par exemple) situées à l'intérieur de l'enceinte 32 permettent de mesurer la température des échantillons. La température mesurée est envoyée, via un circuit électronique de lecture 52, vers le calculateur 46 en vue de réguler la température de chauffe et la durée des irradiations thermiques. A cet effet, le calculateur 46 est relié à un circuit électronique 54 de commande et d'alimentation électrique des lampes à halogène 48.

Le dispositif décrit ci-dessus permet une régulation automatique des températures de dépôts et d'irradiations thermiques ainsi qu'une régulation des débits gazeux en fonction de la nature du substrat en matériau III-V à traiter, de la nature de l'étape de préparation de surface de ces substrats, du type de dépôt de la couche isolante et éventuellement de celui de la couche conductrice pour une structure MIS.

La description précédente n'a bien entendu été donnée qu'à titre illustratif, toute modification, sans pour autant sortir du cadre de l'invention, pouvant être envisagée. En particulier le dispositif pour la mise en oeuvre de l'invention peut avoir une configuration verticale au lieu d'une configuration horizontale.

**Revendications**

1. Procédé de formation d'une couche électriquement isolante (12) sur un substrat (6) en matériau III-V, caractérisé en ce qu'il comprend au moins une première étape (A) de préparation de la surface du substrat (6) consistant à recouvrir cette surface d'au moins une couche de protection (8, 10), cette étape pouvant être précédée par une étape de mise a nu de ladite surface, et une seconde étape (B)

10

de dépôt chimique en phase vapeur de ladite couche isolante (12), a haute température, c'est-à-dire à une température supérieure à la température de décomposition non congruente de la surface du substrat, le chauffage du substrat (6) au cours de l'étape (B) étant réalisé par un seul flash thermique correspondant à une montée en température extrêmement rapide voisine de 5 secondes, une descente en température extrêmement rapide voisine de 12 secondes et un palier à la température de dépôt choisie dont la durée est fonction de l'épaisseur recherchée pour la couche isolante.

2. Procédé selon la revendication 1, caractérisé en ce que la première étape (A) est réalisée en soumettant le substrat (6) à un flash thermique.

3. Procédé selon la revendication 1 ou 2, caractérisé en ce que la première et la seconde étapes sont réalisées dans une même enceinte (32).

4. Procédé selon l'une quelconque des revendications 1 à 3, caractérisé en ce que le matériau est choisi parmi GaAs, InP, $Ga_xIn_{1-x}As_yP_{1-y}$ et $Al_xGa_yIn_{1-x-y}As$ avec $0{\leqq}x{\leqq}1$ et $0{\leqq}y{\leqq}1$.

5. Procédé selon l'une quelconque des revendications 1 à 4, caractérisé en ce que l'on soumet le substrat (6) au flash thermique à l'aide de lampes à halogène (48).

6. Procédé selon l'une quelconque des revendications 1 à 5, caractérisé en ce que la première étape (A) comporte une étape de décapage de la surface du substrat (6) pour la mettre à nu.

7. Procédé selon l'une quelconque des revendications 1 à 6, caractérisé en ce que l'étape de mise à nu de ladite surface (6) est realisée sous vide pour dégager l'oxyde natif du substrat.

8. Procédé selon l'une quelconque des revendications 1 à 6, caractérisé en ce que l'étape de mise à nu de ladite surface (6) est réalisée en présence d'un gaz chloré.

9. Procédé selon l'une quelconque des revendications 1 à 8, caractérisé en ce que l'étape (A) comporte une étape (8a) d'apport en élément V à la surface du substrat pour la recouvrir d'une couche de protection.

10. Procédé selon l'une quelconque des revendications 1 à 9, caractérisé en ce que la première étape (A) comporte une étape d'encapsulation (10a) de la surface du substrat (6) par un matériau isolant (10) pour la protéger.

11. Procédé selon l'une quelconque des revendications 1 à 9, caractérisé en ce que la première étape (A) comporte une étape d'épitaxie d'une couche semiconductrice à la surface du substrat pour la protéger.

12. Procédé selon l'une quelconque des revendications 1 à 11, caractérisé en ce que la couche isolante (12) est une couche de silicium polycristallin non dopé, une couche de nitrure de silicium ou une couche d'oxyde de silicium.

13. Procédé selon l'une quelconque des revendications 1 à 11, caractérisé en ce que la seconde étape (B) consiste à déposer à la surface du substrat, sous flash thermique, une couche de silicium polycristallin, puis à oxyder ou nitrurer thermiquement cette couche de silicium.

14. Procédé de fabrication d'une structure (1) MIS sur un substrat en matériau III-V (2), comportant une couche électriquement isolante (12) surmontée d'une couche conductrice (14), caractérisé en ce que l'on dépose la couche isolante (12) conformément au procédé selon l'une quelconque des revendications 1 à 13, puis en ce que l'on dépose sur cette couche isolante, à une température comprise entre 700 et 950°C, la couche conductrice (14).

15. Procédé selon la revendication 14, caractérisé en ce que la couche conductrice (14) étant en silicium polycristallin fortement dopé, on soumet, simultanément au dépôt de cette couche conductrice, la surface de la structure (1) à un flash thermique.

16. Procédé selon la revendication 14, caractérisé en ce que la couche conductrice (14) étant en métal, on dépose cette couche par pyrolyse de carbonyle ou d'hexafluorure dudit métal.

**17.** Procédé selon l'une quelconque des revendications 14 à 16, caractérisé en ce que les dépôts de la couche isolante (12) et de la couche conductrice (14) sont effectués dans une même enceinte de dépôt (32).

**Claims**

**1.** Process for the formation of an electrically insulating layer (12) on a III-V material substrate (6), characterized in that it comprises at least one first stage A of preparing the surface of the substrate (6) consisting of covering said surface with at least one protective layer (8, 10) and in which said stage can be preceded by a stage of exposing said surface, and a second stage B of chemical vapour deposition of said insulating layer (12) at high temperature, i.e. a temperature exceeding the non-congruent decomposition temperature of the substrate surface, the heating of the substrate (6) during stage B being carried out by a single heat flash corresponding to an extremely fast temperature rise of approximately 5 seconds, an extremely fast temperature drop of approximately 12 seconds and a deposition temperature plateau whose duration is a function of the thickness sought for the insulating layer.

**2.** Process according to claim 1, characterized in that the first stage A is performed by subjecting the substrate (6) to a heat flash.

**3.** Process according to claims 1 or 2, characterized in that the first and second stages are performed in the same enclosure (32).

**4.** Process according to any one of the claims 1 to 3, characterized in that the material is chosen from among GaAs, Inp, $Ga_xIn_{1-x}As_yP_{1-y}$ and $Al_xGa_yIn_{1-x-y}As$ with $0{\leq}x{\leq}1$ and $0{\leq}y{\leq}1$.

**5.** Process according to any one of the claims 1 to 4, characterized in that the substrate (6) is subjected to the heat flash with the aid of tungsten halogen lamps (48).

**6.** Process according to any one of the claims 1 to 5, characterized in that the first stage A has a stage of etching the surface of the substrate (6) in order to expose it.

**7.** Process according to any one of the claims 1 to 6, characterized in that the stage of exposing said surface (6) takes place in vacuo in order to give off the native oxide of the substrate.

**8.** Process according to any one of the claims 1 to 6, characterized in that the stage of exposing the said surface (6) is performed in the presence of a chlorine gas.

**9.** Process according to any one of the claims 1 to 8, characterized in that the stage A incorporates a stage (8a) of supplying V element to the substrate surface in order to cover it with a protective layer.

**10.** Process according to any one of the claims 1 to 9, characterized in that the first stage A incorporates an encapsulation stage (10a) of the surface of the substrate (6) by an insulating material (10) in order to protect the same.

**11.** Process according to any one of the claims 1 to 9, characterized in that the first stage A incorporates an epitaxy stage of a semiconductor layer on the substrate surface in order to protect it.

**12.** Process according to any one of the claims 1 to 11, characterized in that the insulating layer (12) is an undoped polycrystalline silicon layer, a silicon nitride layer or a silicon oxide layer.

**13.** Process according to any one of the claims 1 to 11, characterized in that the second stage B consists of depositing on the substrate surface, under a heat flash, a polycrystallized silicon layer, followed by the thermal nitriding or oxidizing of said silicon layer.

**14.** Process for the production of a MIS structure (1) on a III-V material substrate (2), comprising an electrically insulating layer (12) surmounted by a conductive layer (14), characterized in that the insulating layer (12) is deposited in accordance with the process of any one of the claims 1 to 13 and in that on said insulating layer the conductive layer (14) is deposited at a temperature between 700 and 950°C.

15. Process according to claim 14, characterized in that the conductive layer (14) is of highly doped polycrystalline silicon, so that simultaneously with the deposition of said conductive layer, the surface of the substrate (1) is exposed to a heat flash.

16. Process according to claim 14, characterized in that as the conductive layer (14) is of metal, said layer is deposited by pyrolysis of carbonyl or hexafluoride of said metal.

17. Process according to any one of the claims 14 to 16, characterized in that the depositions of the insulating layer (12) and the conductive layer (14) are performed in the same deposition enclosure (32).

## Patentansprüche

1. Verfahren zur Bildung einer elektrischen Isolierschicht (12) auf einem Substrat (6) aus III-V-Material, dadurch gekennzeichnet, daß es wenigstens einen ersten Schritt (A) der Vorbereitung der Substratoberfläche (6), welcher aus dem Beschichten dieser Oberfläche mit wenigstens einer Schutzschicht (8, 10) besteht, wobei diesem Schritt ein Schritt der Freilegung der Oberfläche vorangehen kann, und einen zweiten Schritt (B) des chemischen Dampfphasenniederschlags der Isolierschicht (12) bei hoher Temperatur, das heißt bei einer höheren Temperatur als der nichtkongruenten Zersetzungstemperatur der Substratoberfläche umfaßt, wobei das Erhitzen des Substrats (6) im Verlauf von Schritt (B) mittels eines einzelnen Wärmeblitzes durchgeführt wird, was mit einem äußerst raschen Temperaturanstieg nahe bei 5 Sekunden, einem äußerst raschen Absinken der Temperatur nahe bei 12 Sekunden und einer Stufe in der gewählten Niederschlagstemperatur verbunden ist, deren Dauer eine Funktion der für die Isolierschicht angestrebten Dicke ist.

2. Verfahren gemäß Anspruch 1, dadurch gekennzeichnet, daß der erste Schritt (A) dadurch ausgeführt wird, daß das Substrat (6) einem Wärmeblitz unterworfen wird.

3. Verfahren gemäß Anspruch 1 oder 2, dadurch gekennzeichnet, daß der erste und der zweite Schritt im selben Behältnis (32) durchgeführt werden.

4. Verfahren gemäß einem der Ansprüche 1 bis 3, dadurch gekennzeichnet, daß das Material aus GaAs, InP, $Ga_xIn_{1-x}As_yP_{1-y}$ und $Al_xGa_yIn_{1-x-y}$ mit $0{\leq}x{\leq}1$ und $0{\leq}y{\leq}1$ ausgewählt ist.

5. Verfahren gemäß einem der Ansprüche 1 bis 4, dadurch gekennzeichnet, daß man das Substrat (6) einem Wärmeblitz mit Hilfe von Halogenlampen (48) unterwirft.

6. Verfahren gemäß einem der Ansprüche 1 bis 5, dadurch gekennzeichnet, daß der erste Schritt (A) einen Schritt des Abbeizens der Oberfläche des Substrats (6) enthält, um sie freizulegen.

7. Verfahren gemäß einem der Ansprüche 1 bis 6, dadurch gekennzeichnet, daß der Schritt des Freilegens der Oberfläche (6) im Vakuum durchgeführt wird, um das aus dem Substrat stammende Oxid abzulösen.

8. Verfahren gemäß einem der Ansprüche 1 bis 6, dadurch gekennzeichnet, daß der Schritt des Freilegens der Oberfläche (6) in Gegenwart von Chlorgas durchgeführt wird.

9. Verfahren gemäß einem der Ansprüche 1 bis 8, dadurch gekennzeichnet, daß der erste Schritt (A) einen Schritt (8a) der Zufuhr von Element V zur Substratoberfläche enthält, um sie mit einer Schutzschicht zu beschichten.

10. Verfahren gemäß einem der Ansprüche 1 bis 9, dadurch gekennzeichnet, daß der erste Schritt (A) einen Schritt (10a) des Verschließens der Oberfläche des Substrats (6) mit einem Isoliermaterial (10) enthält, um sie zu schützen.

**11.** Verfahren gemäß einem der Ansprüche 1 bis 9, dadurch gekennzeichnet, daß der erste Schritt (A) einen Epitaxieschritt einer halbleitenden Schicht auf der Substratoberfläche enthält, um sie zu schützen.

**12.** Verfahren gemäß einem der Ansprüche 1 bis 11, dadurch gekennzeichnet, daß die Isolierschicht (12) eine nichtdotierte Schicht aus polykristallinem Silicium, eine Schicht aus Siliciumnitrid oder eine Schicht aus Siliciumoxid ist.

**13.** Verfahren gemäß einem der Ansprüche 1 bis 11, dadurch gekennzeichnet, daß der zweite Schritt (B) daraus besteht, auf der Substratoberfläche unter einem Wärmeblitz eine Schicht aus polykristallinem Silicium niederzuschlagen und darauf diese Siliciumschicht thermisch zu oxydieren oder nitrieren.

**14.** Verfahren zur Herstellung einer MIS-Struktur (1) auf einem Substrat aus III-V-Material (2), welches eine elektrisch isolierende, mit einer leitenden Schicht (14) versehene Schicht (12) enthält, dadurch gekennzeichnet, daß man die Isolierschicht (12) nach einem Verfahren gemäß einem der Ansprüche 1 bis 13 niederschlägt und man darauf auf dieser Isolierschicht bei einer Temperatur zwischen 700 und 950°C die leitende Schicht (14) niederschlägt.

**15.** Verfahren gemäß Anspruch 14, dadurch gekennzeichnet, daß man gleichzeitig mit dem Niederschlag der aus hochdotiertem, polykristallinem Silicium bestehenden leitenden Schicht (14) die Oberfläche der Struktur (1) einem Wärmeblitz aussetzt.

**16.** Verfahren gemäß Anspruch 14, dadurch gekennzeichnet, daß man die aus Metall bestehende leitende Schicht (14) durch Pyrolyse eines Carbonyls oder Hexafluorids des Metalls niederschlägt.

**17.** Verfahren gemäß einem der Ansprüche 14 bis 16, dadurch gekennzeichnet, daß der Niederschlag der Isolierschicht (12) und der leitenden Schicht (14) im selben Niederschlagsbehälter (32) durchgeführt werden.

14

FIG. 1

FIG. 2a

FIG. 2b

FIG. 3

FIG. 4

FIG. 5

FIG. 6

FIG. 7